# EUROPEAN PATENT APPLICATION

(11) **EP 3 349 259 A1**
(43) Date of publication of application: **18.07.2018**
(21) Application number: 17151608.1
(22) Date of filing: 16.01.2017
(51) Int. Cl.: H01L 33/62, F21V 19/00, H01L 33/64

(54) **LIGHT EMITTING DEVICE**

(71) Applicant: Lumileds Holding B.V., 1118 BG Schiphol (NL)
(72) Inventor: The designation of the inventor has not yet been filed
(74) Representative: Rüber, Bernhard Jakob

(57) **Abstract**

A light emitting device (100) is described herein, comprising: a LED module (101) comprising: a ceramic substrate (102), and at least one LED chip (103) and a first conductor pattern (104) arranged on the ceramic substrate (102), with the first conductor pattern (104) electrically connecting to the at least one LED chip (103); a connection board (106) comprising a connection substrate (107) which consists of a material different from that of the ceramic substrate (102) and which has a second conductor pattern (108) thereon, the second conductor pattern (108) being connected to the first conductor pattern (104); and a heat sink (1012) for dissipating heat conducted from the ceramic substrate (102); wherein the connection substrate (107) comprises an opening (109) for accommodating the LED module (101) such that the LED module (101) is at least partially surrounded by the connection substrate (107). In this way, the size of the ceramic substrate can be made as small as possible, so that the light emitting devices could have a lower cost.

## Description

### TECHNICAL FIELD

This disclosure relates to a field of lighting, and specifically to a light emitting device.

### BACKGROUND

In recent years, LED-based light emitting devices are widely used in various aspects of life, such as in a vehicle as a headlight. Most of LED-based light emitting devices employ a single substrate, which is typically a ceramic substrate due to its good thermal conductivity. Such a ceramic substrate is typically a big piece of ceramic substrate with LED chips and several components (such as resistors, capacitors, connectors and so on) mounted thereon. Then, the single ceramic substrate is soldered onto a regular printed circuit board (PCB).

However, since ceramic substrates are very expensive and also quite difficult to process, the LED-based light emitting devices made in this way often have some disadvantages such as high cost, poor process yield, and the like.

### SUMMARY

A general object of the present disclosure is to provide an improved light emitting device which could overcome the above-mentioned and other possible drawbacks.

According to the present disclosure, there is provided a light emitting device comprising: a LED module comprising: a ceramic substrate , and at least one LED chip and a first conductor pattern arranged on the ceramic substrate, with the first conductor pattern electrically connecting to the at least one LED chip; a connection board comprising a connection substrate which consists of a material different from that of the ceramic substrate and which has a second conductor pattern thereon, the second conductor pattern being connected to the first conductor pattern; and a heat sink for dissipating heat conducted from the ceramic substrate; wherein the connection substrate comprises an opening for accommodating the LED module such that the LED module is at least partially surrounded by the connection substrate.

This is advantageous in that only LED chips are mounted on the ceramic substrate, and other components (such as resistors, capacitors, connectors and so on) can be mounted on the connection substrate, so that the size of the ceramic substrate can be made as small as possible. Thus, the light emitting devices in the present disclosure could have a lower cost. Moreover, such a light emitting device is easy to manufacture, therefore a good process yield can be achieved.

In an embodiment, the second conductor pattern can be connected to the first conductor pattern by soldering. Additionally or alternatively, the second conductor pattern can be connected to the first conductor pattern by soldering a metal sheet between them. The soldering provides a mechanical fixation and an electrical connection between the LED module and the connection board.

In an embodiment, the ceramic substrate and the connection substrate can be fixed together by an adhesive, which could provide and/or enhance the fixation between the LED module and the connection board.

In an embodiment, the second conductor pattern can be connected to the first conductor pattern through a flexible and electrically conductive connection. As an example, the second conductor pattern can be connected to the first conductor pattern by wire bonding or ribbon bonding. As another example, the second conductor pattern can be connected to the first conductor pattern through a spring. With the flexible and electrically conductive connection, the electrical connection between the first conductive pattern and the second conductive pattern can be preserved to the greatest extent.

In an embodiment, the spring can be arranged to, when the ceramic substrate moves relative to the connection substrate, generate a spring force in a direction opposite to the moving direction of the ceramic substrate. In this way, a relatively fixed position between the ceramic substrate and the connection substrate can be guaranteed.

In an embodiment, the spring can be arranged to flexibly press the ceramic substrate onto the heat sink by means of a spring force generated by the spring, which can prevent, to some extent, a separation or a non-contact state between the ceramic substrate and the heat sink.

In an embodiment, the connection substrate and the heat sink can be fixed together. This is advantageous for the robustness of the construction of the light emitting device.

In an embodiment, the heat sink can comprise a protrusion that supports and is in thermal contact to the ceramic substrate. Additionally or alternatively, the ceramic substrate can comprise a protrusion which protrudes from the connection substrate to contact the heat sink. Such a protrusion can facilitate a thermal contact of the heat sink with the ceramic substrate. In the case that the connection substrate and the heat sink are fixed together, the protrusion can cause the spring to generate the spring force for pressing the ceramic substrate onto the heat sink.

These and other advantages of the disclosure will be apparent from and elucidated with reference to the embodiments described hereinafter.

### BRIEF DESCRIPTION OF THE DRAWINGS

The disclosure will now be described in more detail and with reference to the appended drawings in which:
- Fig. 1: is an example structure drawing of an embodiment of a light emitting device according to the disclosure;
- Fig. 2: illustrates an exploded view of the light emitting device of figure 1.
- Fig. 3: is an example structure drawing of another embodiment of a light emitting device according to the disclosure; and
- Fig. 4: is a schematic cross-sectional view of a light emitting device according to the disclosure.

### DETAILED DESCRIPTION

The present disclosure will now be described more fully with reference to the accompanying drawings, in which currently preferred embodiments of the disclosure are shown. The disclosure may, however, be embodied in many different forms and should not be construed as limited to the embodiments set forth herein; rather, these embodiments are provided for thoroughness and completeness, and fully convey the scope of the invention to the person skilled in the art. Like reference numbers refer to like elements throughout. It is also intended that the terminology used in this disclosure be interpreted in its broadest reasonable manner, even though it is being used in conjunction with a detailed description of certain embodiments of the disclosure.

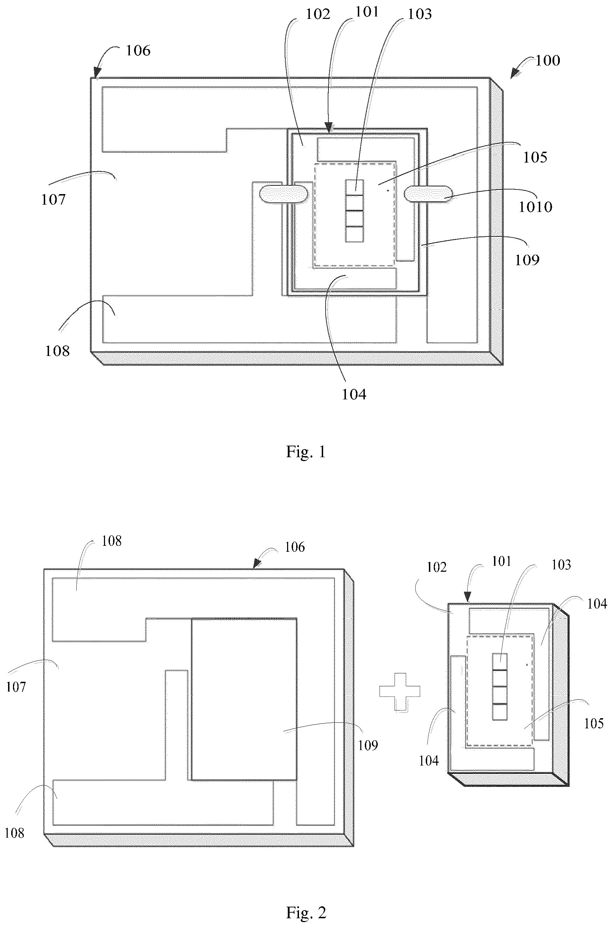

Figure 1 is an example structure drawing of a first embodiment of a light emitting device 100 according to the disclosure. As shown, the light emitting device 100 comprises a LED module 101, and a connection board 106. Moreover, the light emitting device 100 can also comprise a heat sink for dissipating heat conducted from the ceramic substrate 102, which is not shown in figure 1.

For the sake of clarity, figure 2 illustrates an exploded view of the light emitting device 100 of figure 1. As shown in figure 2, the LED module 101 comprises a ceramic substrate 102, and also comprises at least one LED chip 103 and a first conductor pattern 104 arranged on the ceramic substrate 102. The at least one LED chip 103 can be mounted on the ceramic substrate 102 by, for example, eutectic, glue, soldering paste and so on. The first conductor pattern 104 is electrically connected to the at least one LED chip 103. The at least one LED chip 103 can emit light when being supplied with electric power. The first conductor pattern 104 can be formed on the ceramic substrate 102 in a variety of ways, for example through a pattern printing process which is well known in the art.

In an embodiment, the LED module 101 could also comprise a dam 105 which is arranged around the at least one LED chip 103 to avoid the loss of light from the sides of the at least one LED chip 103. The dam 105 may, for example, be TiO2 which is dispensed and cured around the at least one LED chip 103.

The connection board 106 can comprise a connection substrate 107 consisting of a material different from that of the ceramic substrate 102 and having a second conductor pattern 108 printed thereon. The second conductor pattern 108 can also be formed on the connection substrate 107 in a variety of ways, for example through a pattern printing process. The connection board 106 can typically be a regular printed circuit board (PCB), the substrate of which is made of, for example, FR-4. The connection substrate 107 can also comprise an opening 109 which is arranged for accommodating the LED module 101 such that the LED module 101 is at least partially surrounded by the connection substrate 107. Moreover, the opening 109 may have any shape, such as rectangular, circular and so on. It should be noted that the opening 109 could completely or incompletely surround the LED module 101.

Back to figure 1, the second conductor pattern 108 can be connected to the first conductor pattern 104 by soldering. The soldering plays two roles herein: one for electrically connecting the first conductive pattern 104 to the second conductive pattern 108 so as to, for example, provide external power to the LED module 101, particularly to the at least one LED chip 103; and the other for rigidly and mechanically fixing to each other the LED module 101 (particularly the ceramic substrate 102 thereof) and the connection board 106 (particularly the connection substrate 107 thereof). This is generally suitable for the case where the gap between the ceramic substrate 102 and the connection substrate 107 is relatively small. In this case, the solder paste can even fill the entire gap to enhance the fixation between the LED module 101 and the connection board 106.

Additionally or alternatively, the second conductor pattern 108 can be connected to the first conductor pattern 104 by soldering a metal sheet 1010 between them, as shown in figure 1. The metal sheet 1010 between them could further provide or enhance the fixation between the LED module 101 and the connection board 106 while electrically connecting the second conductor pattern 108 and the first conductor pattern 104. This is generally suitable for the case where the gap between the ceramic substrate 102 and the connection substrate 107 is relatively large.

Optionally, the connection substrate 107 can be mechanically fixed together with the ceramic substrate 102 by an adhesive, which could also provide or enhance the fixation between the LED module 101 and the connection board 106. It should be noted that other ways for fixing the connection substrate 107 and the ceramic substrate 102 together are also contemplated.

In an embodiment, the second conductor pattern 108 can be connected to the first conductor pattern 104 through a flexible and electrically conductive connection. Due to a mismatch in the thermal expansion behavior between the LED module 101 and the connection board 106 or due to an impact that the light emitting device 100 may be subjected to, the solder connection and/or the adhesive connection between the LED module 101 and the connection board 106 may eventually break, which may lead to premature failure of the light emitting device 100. With the flexible and electrically conductive connection, the electrical connection between the first conductive pattern 104 and the second conductive pattern 108 can be preserved to the greatest extent, thereby increasing the possibility that the light emitting device 100 will function normally.

As an example, the flexible and electrically conductive connection can be achieved by wire bonding or ribbon bonding. That is to say, the second conductor pattern 108 is connected to the first conductor pattern 104 by wire bonding or ribbon bonding. Since the strength of the wire bonding or ribbon bonding is relatively weak, the connection substrate 107 can be further fixed together with the ceramic substrate 102 by an adhesive as described above.

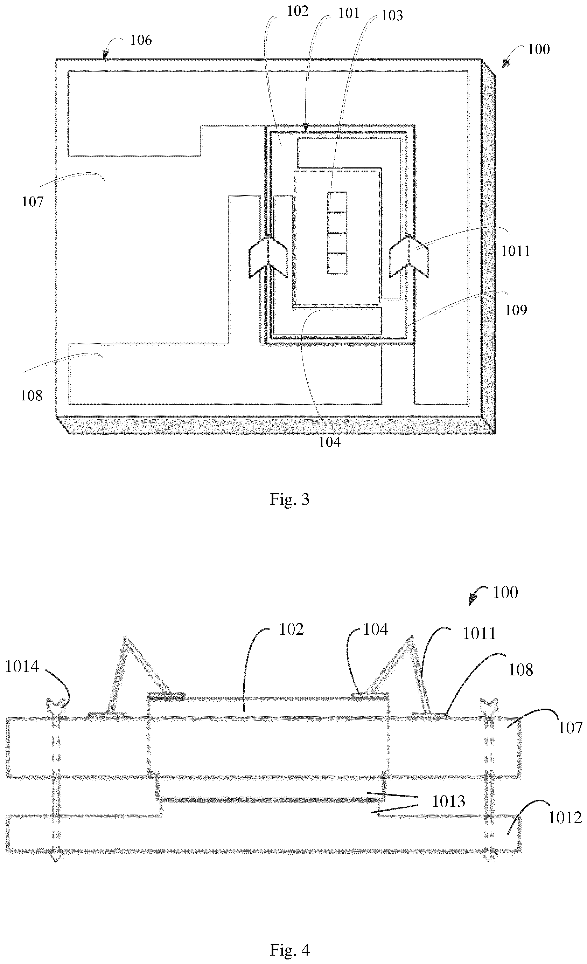

As another example, the flexible and electrically conductive connection can be achieved by a spring 1011. The spring 1011 can connect the second conductor pattern 108 to the first conductor pattern 104 by soldering or in any other manner. The spring 1011 may, for example, be a metal sheet with a buffer kink, as shown in figure 3. Of course, other types of springs are also contemplated.

The spring 1011 can be arranged, when the ceramic substrate 102 moves relative to the connection substrate 107, to generate a spring force in a direction opposite to the moving direction of the ceramic substrate 102. In this case, even when the rigid mechanical connection between the ceramic substrate 102 and the connection substrate 107 is broken or does not exist at all, a relatively fixed position between the ceramic substrate 102 and the connection substrate 107 can be guaranteed while securing the electrical connection between the first conductive pattern 104 and the second conductive pattern 108.

The spring 1011 can also be arranged to flexibly press the ceramic substrate 102 onto the heat sink by means of a spring force generated by the spring 1011. In this case, such a spring force can further prevent, to some extent, a separation or a non-contact state between the ceramic substrate 102 and the heat sink caused by a small displacement in the vertical direction between the ceramic substrate 102 and the connection substrate 107. The heat sink will be described in detail below.

Figure 4 is a schematic cross-sectional view of a light emitting device 100 according to the disclosure. As shown, the light emitting device 100 comprises a heat sink 1012 which is used for dissipating heat conducted from the ceramic substrate 102. The heat sink 1012 can be thermally connected with the ceramic substrate 102 by means of, for example, a heat-conducting glue. The heat-conducting glue could further play a role in fixing the heat sink 1012 and the ceramic substrate 102.

In an embodiment, the heat sink 1012 could comprise a protrusion 1013 which supports and is thermally connected with the ceramic substrate 102, as shown in figure 4. Additionally or alternatively, the ceramic substrate 102 can comprise a protrusion 1013 which protrudes from the connection substrate 107 to contact the heat sink 1012. Such a protrusion 1013 can facilitate a thermal contact of the heat sink 1012 with the ceramic substrate 102.

As shown, the second conductor pattern 108 is connected to the first conductor pattern 104 through a spring 1011. The spring 1011 flexibly presses the ceramic substrate 102 onto the heat sink 1012. In this case, the connection substrate 107 and the heat sink 1012 can be further fixed together, for example, by screws 1014. It should be noted that the connection substrate 107 and the heat sink 1012 may also be fixed by nails, glue, or the like. This is advantageous for the robustness of the construction of the light emitting device 100. Even if the ceramic substrate 102 moves vertically or horizontally with respect to the connection substrate 107, the movement is very small and the original position between them can be quickly restored.

In the case that the connection substrate 107 and the heat sink 1012 are fixed together, the protrusion 1013 can squeeze the ceramic substrate 102, causing the spring 1011 to generate the spring force for pressing the ceramic substrate 102 onto the heat sink 1012. Moreover, the protrusion 1013 is also advantageous for the design or manufacture of the light emitting device 100. For example, the protrusion 1013 may be designed to be sufficiently smooth to avoid a need for other heat-conducting media between them, such as a heat-conducting glue.

Although the present disclosure has been described in connection with some embodiments, it is not intended to be limited to the specific form set forth herein. Rather, the scope of the present disclosure is limited only by the accompanying claims. Additionally, although individual features may be included in different claims, these may possibly be advantageously combined, and the inclusion in different claims does not imply that a combination of features is not feasible and/or advantageous. In addition, in the claims, the word "comprise" or "include" does not exclude other elements, and the indefinite article "a" or "an" does not exclude a plurality. Reference signs in the claims are provided merely as a clarifying example and shall not be construed as limiting the scope of the claims in any way.

### LIST OF REFERENCE SIGNS:

- 100: light emitting device
- 101: LED module
- 102: ceramic substrate
- 103: LED chip
- 104: first conductor pattern
- 105: dam
- 106: connection board
- 107: connection substrate
- 108: second conductor pattern
- 109: opening in connection substrate 107
- 1010: metal sheet
- 1011: spring
- 1012: heat sink
- 1013: protrusions
- 1014: screws

## Claims

1. A light emitting device (100) comprising:
a LED module (101) comprising: a ceramic substrate (102), and at least one LED chip (103) and a first conductor pattern (104) arranged on the ceramic substrate (102), with the first conductor pattern (104) electrically connecting to the at least one LED chip (103);
a connection board (106) comprising a connection substrate (107) which consists of a material different from that of the ceramic substrate (102) and which has a second conductor pattern (108) thereon, the second conductor pattern (108) being connected to the first conductor pattern (104); and
a heat sink (1012) for dissipating heat conducted from the ceramic substrate (102);
wherein the connection substrate (107) comprises an opening (109) for accommodating the LED module (101) such that the LED module (101) is at least partially surrounded by the connection substrate (107).

2. The light emitting device (100) according to claim 1, wherein the second conductor pattern (108) is connected to the first conductor pattern (104) by soldering.

3. The light emitting device (100) according to claim 2, wherein the second conductor pattern (108) is connected to the first conductor pattern (104) by soldering a metal sheet (1010) between them.

4. The light emitting device (100) according to claim 1 or 2, wherein the second conductor pattern (108) is connected to the first conductor pattern (104) through a flexible and electrically conductive connection.

5. The light emitting device (100) according to claim 1 or 2, wherein the ceramic substrate (102) and the connection substrate (107) are fixed together by an adhesive.

6. The light emitting device (100) according to claim 4, wherein the second conductor pattern (108) is connected to the first conductor pattern (104) by wire bonding or ribbon bonding.

7. The light emitting device (100) according to claim 4, wherein the second conductor pattern (108) is connected to the first conductor pattern (104) through a spring (1011).

8. The light emitting device (100) according to claim 7, wherein the spring (1011) is arranged to, when the ceramic substrate (102) moves relative to the connection substrate (107), generate a spring force in a direction opposite to the moving direction of the ceramic substrate (102).

9. The light emitting device (100) according to claim 7, wherein the spring (1011) is arranged to flexibly press the ceramic substrate (102) onto the heat sink (1012) by means of a spring force generated by the spring (1011).

10. The light emitting device (100) according to claim 9, wherein the connection substrate (107) and the heat sink (1012) are fixed together.

11. The light emitting device (100) according to claim 1 or 2, wherein the heat sink (1012) comprises a protrusion (1013) that supports and is in thermal contact to the ceramic substrate (102).

12. The light emitting device (100) according to claim 1 or 2, wherein the ceramic substrate (102) comprises a protrusion (1013) which protrudes from the connection substrate (107) to contact the heat sink (1012).
